# EUROPEAN PATENT SPECIFICATION

(11) **EP 3 257 969 B1**
(45) Date of publication and mention of the grant of the patent: **22.04.2020**
(21) Application number: 16748997.0
(22) Date of filing: 21.01.2016
(51) Int. Cl.: C23F 1/44, C23F 1/26, C23G 5/032, C23G 5/036, H05K 3/06, H01L 21/3213

(54) **ETCHING LIQUID AND ETCHING METHOD**
ÄTZFLÜSSIGKEIT UND ÄTZVERFAHREN
LIQUIDE DE GRAVURE ET PROCÉDÉ DE GRAVURE

(30) Priority: 12.02.2015 JP 2015025385
(43) Date of publication of application: 20.12.2017
(73) Proprietor: MEC COMPANY LTD., Amagasaki-shi Hyogo 6600822 (JP)
(72) Inventor: OGINO, Yuki, Amagasaki-shi Hyogo 660-0822 (JP); TOJIMA, Mami, Amagasaki-shi Hyogo 660-0822 (JP); HAYASHIZAKI, Masahiro, Amagasaki-shi Hyogo 660-0822 (JP); OTANI, Minoru, Amagasaki-shi Hyogo 660-0822 (JP)
(74) Representative: HGF Limited
(86) International application number: PCT/JP2016/051690
(87) International publication number: WO 2016/129352

(56) References cited:
- WO-A1-2014/203649
- CN-A- 101 210 343
- JP-A- H06 280 056
- JP-A- 2009 512 194
- JP-A- 2013 135 039
- JP-A- 2014 103 179
- US-A- 4 004 956
- US-A- 4 588 471
- US-A1- 2003 150 840
- US-A1- 2008 073 614

## Description

### TECHNICAL FIELD

The present invention relates to etching liquids for etching titanium selectively in the presence of copper, and an etching method thereof.

### BACKGROUND ART

Hitherto, for the etching of titanium, an etching liquid containing hydrofluoric acid or hydrogen peroxide has been used. For example, Patent Document 1 suggests an etching liquid for etching titanium in the presence of copper or aluminum, the pH of this liquid being adjusted into the range of 7 to 9 with an aqueous solution including 10 to 40% by weight of hydrogen peroxide, 0.05 to 5% by weight of phosphoric acid, 0.001 to 0.1% by weight of a phosphonic acid-based compound, and ammonia.

However, the etching liquid containing hydrofluoric acid has a problem of being high in toxicity. The etching liquid containing hydrogen peroxide has a problem of being poor in storage stability.

### PRIOR ART DOCUMENT

### PATENT DOCUMENT

Patent Document 1: Japanese Patent No. 4471094

US 2008/073614 A1, US 4 588 471 A, US 2003/150840 A1, US 4 004 956 A, JP H06 280056 A and WO 2014/203649 A1 disclose the selectively etching of different metals in the presence of copper, without attacking copper.

### SUMMARY OF THE INVENTION

### PROBLEMS TO BE SOLVED BY THE INVENTION

In the light of the above-mentioned actual situation, the present invention has been made, and an object thereof is to provide etching liquids which are capable of etching titanium selectively in the presence of copper, and are further low in toxicity and excellent in storage stability; and an etching method using these etching liquids.

### MEANS FOR SOLVING THE PROBLEMS

The present invention relates to an etching liquid as defined in claim 1.

The present invention also relates to an etching method as defined in claim 7. The etching liquid used in the etching method as defined in claim 7 for etching titanium selectively in the presence of copper comprises:
at least one acid selected from the group consisting of sulfuric acid, hydrochloric acid, and trichloroacetic acid; and
at least one organic sulfur compound selected from the group consisting of a thioketone compound and a thioether compound.

It is preferred that the thioketone compound be at least one selected from the group consisting of thiourea, diethylthiourea, and trimethylthiourea.

It is preferred that the thioether compound be at least one selected from the group consisting of methionine, ethionine, and 3-(methylthio)propionic acid.

The etching liquids of the present invention preferably further comprises an α-hydroxycarboxylic acid, and/or a salt thereof.

It is preferred that the α-hydroxycarboxylic acid be at least one selected from the group consisting of tartaric acid, malic acid, citric acid, lactic acid, and glyceric acid.

It is preferred that the concentration of the acid(s) be from 20 to 70% by weight, and the concentration of the organic sulfur compound(s) be from 0.01 to 10% by weight. The concentration of the α-hydroxycarboxylic acid and/or the salt thereof is preferably from 0.2 to 5% by weight.

The etching liquid as defined in claim 1 for etching titanium selectively in the presence of copper comprises: at least one acid selected from the group consisting of sulfuric acid, hydrochloric acid, and trichloroacetic acid; and at least one organic sulfur compound selected from a thioether compound, wherein the thioether compound is selected from the group consisting of methionine, a hydrochloride of an alkyl ester of methionine, ethionine, 2-hydroxy-4-(alkylthio)butyric acids, and 3-(alkylthio) propionic acids.

### EFFECT OF THE INVENTION

The etching liquids of the present invention makes it possible to etch titanium selectively in the presence of copper. Moreover, the etching liquid of the present invention substantially contains neither hydrofluoric acid nor hydrogen peroxide to be low in toxicity and excellent in storage stability.

### MODE FOR CARRYING OUT THE INVENTION

The etching liquid used in the etching method as defined in claim 7 is an aqueous solution including at least one acid selected from the group consisting of sulfuric acid, hydrochloric acid, and trichloroacetic acid, and at least one organic sulfur compound selected from the group consisting of a thioketone compound and a thioether compound.

Out of these acids, sulfuric acid is preferred from the viewpoint of a low volatility of the acid, and the stability of the etching speed of the etching liquid.

The concentration of the acid(s) in the etching liquid is not particularly limited, and is preferably from 20 to 70% by weight, more preferably from 30 to 60% by weight. If the acid concentration is less than 20% by weight, the etching liquid tends not to gain a sufficient speed of etching titanium. If the acid concentration is more than 70% by weight, the safety of the etching liquid tends to become a problem.

The organic sulfur compound(s) has/have advantageous effects of functioning as a reductant and a chelating agent.

Examples of the thioketone compound include thiourea, N-alkylthioureas, N,N-dialkylthioureas, N,N'-dialkylthioureas, N,N,N'-trialkylthioureas, N,N,N',N'-tetraalkylthioureas, N-phenylthiourea, N,N-diphenylthiourea, N,N'-diphenylthiourea, and ethylenethiourea. The alkyl group(s) of any one of the alkylthioureas is/are not particularly limited. The alkyl group(s) is/are (each) preferably an alkyl group having 1 to 4 carbon atoms. It is preferred to use, out of these examples, at least one selected from the group consisting of thiourea, diethylthiourea, and trimethylthiourea, which are each excellent in advantageous effects of functioning as a reductant or chelating agent, and in water solubility.

The thioether compound includes methionine, a hydrochloride of an alkyl ester of methionine, ethionine, 2-hydroxy-4-(alkylthio) butyric acids, and 3-(alkylthio)propionic acids. The number of carbon atoms in each of the alkyl groups is not particularly limited, and is preferably from 1 to 4. These compounds may each be partially substituted with one or more hydrogen atoms, or one or more hydroxyl groups, amino groups or other groups. It is preferred to use, out of these examples, at least one selected from the group consisting of methionine, ethionine, and 3-(methylthio)propionic acid, which are each excellent in advantageous effects of functioning as a reductant or chelating agent.

The concentration of the organic sulfur compound(s) in the etching liquid is not particularly limited, and is preferably from 0.01 to 10% by weight, more preferably from 0.2 to 5% by weight. If the concentration of the organic sulfur compound(s) is less than 0.01% by weight, the etching liquid can gain neither a sufficient reducing performance nor a sufficient chelating effect so that the speed of etching titanium tends to be insufficient. If the concentration is more than 10% by weight, the dissolution of the organic sulfur compound(s) in the etching liquid tends to reach a limit.

The etching liquid may include an α-hydroxycarboxylic acid, and/or a salt thereof. The α-hydroxycarboxylic acid, and the salt thereof have advantageous effects of functioning as a chelating agent for titanium, and can therefore restrain the generation of any precipitation of titanium in the etching liquid. Examples of the α-hydroxycarboxylic acid include tartaric acid, malic acid, citric acid, lactic acid, and glyceric acid.

The concentration of the α-hydroxycarboxylic acid and/or the salt thereof in the etching liquid is not particularly limited, and is preferably from 0.2 to 5% by weight, more preferably from 0.5 to 2% by weight from the viewpoint of the chelating effect and the solubility thereof.

The etching liquid may include sulfurous acid and/or a sulfite thereof. Sulfurous acid and the sulfite thereof have advantageous effects of functioning as a reductant, and can therefore improve the speed of etching titanium.

The concentration of sulfurous acid and/or the sulfite thereof in the etching liquid is not particularly limited, and is preferably from 0.02 to 0.5% by weight, more preferably from 0.05 to 0.2% by weight from the viewpoint of the reducing performance and odor thereof.

Besides the above-mentioned components, any other component may be added to the etching liquid as far as the advantageous effects of the present invention are not hindered. Examples of the other component include a surfactant, a component stabilizer, and an antifoaming agent.

The etching liquid can easily be prepared by dissolving the above-mentioned individual components into water. The water is preferably water from which ionic substances and impurities have been removed. The species of the water is preferably, for example, ion exchange water, pure water, and super pure water.

About the etching liquid, it is allowable to blend the individual components with each other to have predetermined concentrations, respectively, when the etching liquid is used; or prepare a concentrated liquid of the etching liquid beforehand, dilute the concentrated liquid immediately before the use, and then use the diluted liquid.

An etching method using the etching liquids of the present invention is not particularly limited. Examples of the method include a method of coating or spraying the etching liquid onto a target object containing copper and titanium, and a method of immersing a target object containing copper and titanium into the etching liquid. The treatment temperature is not particularly limited, and is preferably from 40 to 70°C, more preferably 45 to 55°C from the viewpoint of the etching speed of the etching liquid, and safety. The treatment period is varied in accordance with, for example, the surface state and shape of the target object. The period is usually from 30 to 120 seconds.

### EXAMPLES

The following will describe working examples of the present invention together with comparative examples. The invention should not be interpreted to be limited to the working examples described below.

Each etching liquid was prepared to have one out of compositions shown in Tables 1 and 2. Under conditions described below, an etching test and an etching liquid stability test were conducted. In the etching liquid of each of the compositions shown in Tables 1 and 2, the balance thereof was made of ion exchange water. Each concentration of hydrochloric acid shown in Tables 1 and 2 is the concentration of the acid as hydrogen chloride.

### (Etching Test)

A titanium film was formed into a thickness of 50 nm onto each resin piece by sputtering, and next a copper film was formed into a thickness of 200 nm onto the titanium film. Furthermore, a pattern was formed thereon by electroless plating. The resultant substrate was used as each sample. An etching liquid for copper was used to dissolve the sputtered copper film of the sample to make the titanium film naked. Thereafter, any one of the samples was immersed in the etching liquid of each of Examples 1 to 12 and Comparative Examples 1 to 3 to make an etching test. The results are shown in Table 1.

**[Table 1]**

| | | Percent by weight | Treating temperature (°C) | Etching speed (nm/min.) | |
|---|---|---|---|---|---|
| | | | | Titanium | Copper |
| Example 1 | Sulfuric acid | 55 | 50 | 30 | < 10 |
| | Diethylthiourea | 5 | | | |
| Example 2 | Hydrochloric acid | 30 | 50 | 35 | < 10 |
| | Diethylthiourea | 5 | | | |
| Example 3 | Sulfuric acid | 55 | 50 | 50 | < 10 |
| | Trimethylthiourea | 3 | | | |
| | L-lactic acid | 1 | | | |
| Example 4 | Sulfuric acid | 55 | 50 | 60 | < 10 |
| | DL-methionine | 2 | | | |
| | L-lactic acid | 1 | | | |
| Example 5 | Sulfuric acid | 55 | 50 | 85 | < 10 |
| | 3-(Methylthio)propionic acid | 2 | | | |
| | L-lactic acid | 1 | | | |
| Example 6 | Sulfuric acid | 55 | 50 | 35 | < 10 |
| | Diethylthiourea | 5 | | | |
| | L-lactic acid | 1 | | | |
| | Sulfurous acid | 0.2 | | | |
| Example 7 | Sulfuric acid | 55 | 50 | 55 | < 10 |
| | Trimethylthiourea | 3 | | | |
| | L-lactic acid | 1 | | | |
| | Sulfurous acid | 0.2 | | | |
| Example 8 | Sulfuric acid | 55 | 50 | 30 | < 10 |
| | Diethylthiourea | 5 | | | |
| | Citric acid | 2 | | | |
| Example 9 | Sulfuric acid | 55 | 50 | 30 | < 10 |
| | Diethylthiourea | 5 | | | |
| | Tartaric acid | 1 | | | |
| Example 10 | Sulfuric acid | 55 | 50 | 75 | < 10 |
| | Ethionine | 1 | | | |
| | Tartaric acid | 1 | | | |
| Example 11 | Sulfuric acid | 50 | 50 | 90 | < 10 |
| | Trichloroacetic acid | 5 | | | |
| | DL-methionine | 2 | | | |
| | Citric acid | 2 | | | |
| Example 12 | Hydrochloric acid | 30 | 50 | 40 | < 10 |
| | Trimethylthiourea | 3 | | | |
| | Tartaric acid | 1 | | | |
| Comparative Example 1 | Sulfuric acid | 55 | 50 | < 10 | < 10 |
| | L-lactic acid | 1 | | | |
| Comparative Example 2 | Diethylthiourea | 5 | 50 | < 10 | < 10 |
| | L-lactic acid | 1 | | | |
| Comparative Example 3 | Acetic acid | 60 | 50 | < 10 | < 10 |
| | Diethylthiourea | 5 | | | |
| | L-lactic acid | 1 | | | |

As shown in Table 1, the etching liquids of the present invention make it possible to etch titanium selectively without etching copper.

### (Stability Test of Etching Liquids)

The respective etching liquids of Examples 1, 7 and 12, and Comparative Example 4 were allowed to stand still at room temperature for 2 days, and then the same test as described above was conducted. The etching speed of each of these examples before the still standing was compared with that after the still standing. The results are shown in Table 2.

**[Table 2]**

| | | Percent by weight | Treating temperature (°C) | Before still standing | | After still standing for 2 days | |
|---|---|---|---|---|---|---|---|
| | | | | Etching speed (nm/min.) | | Etching speed (nm/min.) | |
| | | | | Titanium | Copper | Titanium | Copper |
| Example 1 | Sulfuric acid | 55 | 50 | 30 | < 10 | 30 | < 10 |
| | Diethylthiorea | 5 | | | | | |
| Example 7 | Sulfuric acid | 55 | 50 | 55 | < 10 | 55 | < 10 |
| | Trimethylthiourea | 3 | | | | | |
| | L-lactic acid | 1 | | | | | |
| | Sulfurous acid | 0.2 | | | | | |
| Example 12 | Hydrochloric acid | 30 | 50 | 40 | < 10 | 40 | < 10 |
| | Trimethylthiourea | 3 | | | | | |
| | Tartaric acid | 1 | | | | | |
| Comparative Example 4 | Hydrogen peroxide | 10 | 35 | 100 | < 10 | 25 | < 10 |
| | Ammonia | 0.3 | | | | | |

As shown in Table 2, the etching liquids of the present invention are excellent in storage stability, and makes it possible to etch titanium selectively even after stored over a long term.

## Claims

1. An etching liquid for etching titanium selectively in the presence of copper, comprising:
at least one acid selected from the group consisting of sulfuric acid, hydrochloric acid, and trichloroacetic acid; and
at least one organic sulfur compound selected from a thioether compound, wherein the thioether compound is selected from the group consisting of methionine, a hydrochloride of an alkyl ester of methionine, ethionine, 2-hydroxy-4-(alkylthio) butyric acids, and 3-(alkylthio) propionic acids.

2. The etching liquid according to claim 1, wherein the thioether compound is at least one selected from the group consisting of methionine, ethionine, and 3-(methylthio)propionic acid.

3. The etching liquid according to claim 1, wherein the liquid further comprises an α-hydroxycarboxylic acid, and/or a salt thereof.

4. The etching liquid according to any one of claims 1 and 3, wherein the α-hydroxycarboxylic acid is at least one selected from the group consisting of tartaric acid, malic acid, citric acid, lactic acid, and glyceric acid.

5. The etching liquid according to any one of claims 1 to 4, wherein the concentration of the acid(s) is from 20 to 70% by weight, and
the concentration of the organic sulfur compound(s) is from 0.01 to 10% by weight.

6. The etching liquid according to claim 4 or claim 5 , wherein the concentration of the α-hydroxycarboxylic acid and/or the salt thereof is from 0.2 to 5% by weight.

7. An etching method, comprising etching titanium selectively in the presence of copper by using an etching liquid for etching titanium selectively in the presence of copper, comprising:
at least one acid selected from the group consisting of sulfuric acid, hydrochloric acid, and trichloroacetic acid; and
at least one organic sulfur compound selected from the group consisting of a thioketone compound and a thioether compound.

8. The etching method according to claim 7, wherein the thioketone compound is at least one selected from the group consisting of thiourea, diethylthiourea, and trimethylthiourea.

9. The etching method according to claim 7 or claim 8, wherein the thioether compound is at least one selected from the group consisting of methionine, ethionine, and 3-(methylthio)propionic acid.

10. The etching method according to any one of claims 7 to 9, wherein the etching liquid further comprises an α-hydroxycarboxylic acid, and/or a salt thereof.

11. The etching method according to claim 10, wherein the α-hydroxycarboxylic acid is at least one selected from the group consisting of tartaric acid, malic acid, citric acid, lactic acid, and glyceric acid.

12. The etching method according to any one of claims 7 to 11, wherein the concentration of the acid(s) is from 20 to 70% by weight, and
the concentration of the organic sulfur compound(s) is from 0.01 to 10% by weight.

13. The etching method according to claim 10 or claim 11, wherein the concentration of the α-hydroxycarboxylic acid and/or the salt thereof is from 0.2 to 5% by weight.

## Patentansprüche

1. Ätzflüssigkeit zum selektiven Ätzen von Titan in der Gegenwart von Kupfer, umfassend:
mindestens eine Säure, die ausgewählt ist aus der Gruppe bestehend aus Schwefelsäure, Salzsäure und Trichloressigsäure; und
mindestens eine organische Schwefelverbindung, die ausgewählt ist aus einer Thioetherverbindung, wobei die Thioetherverbindung ausgewählt ist aus der Gruppe bestehend aus Methionin, einem Hydrochlorid eines Alkylesters von Methionin, Ethionin, 2-Hydroxy-4-(alkylthio)-Buttersäuren und 3-(Alkylthio)-Propionsäuren.

2. Ätzflüssigkeit nach Anspruch 1, wobei die Thioetherverbindung mindestens eine ist, die ausgewählt ist aus der Gruppe bestehend aus Methionin, Ethionin und 3-(Methylthio)propionsäure.

3. Ätzflüssigkeit nach Anspruch 1, wobei die Flüssigkeit ferner eine α-Hydroxycarboxylsäure und/oder ein Salz davon umfasst.

4. Ätzflüssigkeit nach einem der Ansprüche 1 und 3, wobei die α-Hydroxycarboxylsäure mindestens eine ist, die ausgewählt ist aus der Gruppe bestehend aus Weinsäure, Apfelsäure, Zitronensäure, Milchsäure und Glycerinsäure.

5. Ätzflüssigkeit nach einem der Ansprüche 1 bis 4, wobei die Konzentration der Säure(n) von 20 bis 70 Gew.-% beträgt und
die Konzentration der organischen Schwefelverbindung(en) von 0,01 bis 10 Gew.-% beträgt.

6. Ätzflüssigkeit nach Anspruch 4 oder Anspruch 5, wobei die Konzentration der α-Hydroxycarboxylsäure und/oder des Salzes davon von 0,2 bis 5 Gew.-% beträgt.

7. Ätzverfahren, umfassend selektives Ätzen von Titan in der Gegenwart von Kupfer unter Verwendung einer Ätzflüssigkeit zum selektiven Ätzen von Titan in der Gegenwart von Kupfer, umfassend:
mindestens eine Säure, die ausgewählt ist aus der Gruppe bestehend aus Schwefelsäure, Salzsäure und Trichloressigsäure; und
mindestens eine organische Schwefelverbindung, ausgewählt ist aus der Gruppe bestehend aus einer Thioketonverbindung und einer Thioetherverbindung.

8. Ätzverfahren nach Anspruch 7, wobei die Thioketonverbindung mindestens eine ist, die ausgewählt ist aus der Gruppe bestehend aus Thioharnstoff, Diethylthioharnstoff und Trimethylthioharnstoff.

9. Ätzverfahren nach Anspruch 7 oder Anspruch 8, wobei die Thioetherverbindung mindestens eine ist, die ausgewählt ist aus der Gruppe bestehend aus Methionin, Ethionin und 3-(Methylthio)propionsäure.

10. Ätzverfahren nach einem der Ansprüche 7 bis 9, wobei die Ätzflüssigkeit ferner eine α-Hydroxycarboxylsäure und/oder ein Salz davon umfasst.

11. Ätzverfahren nach Anspruch 10, wobei die α-Hydroxycarboxylsäure mindestens eine ist, die ausgewählt ist aus der Gruppe bestehend aus Weinsäure, Apfelsäure, Zitronensäure, Milchsäure und Glycerinsäure.

12. Ätzverfahren nach einem der Ansprüche 7 bis 11, wobei die Konzentration der Säure(n) von 20 bis 70 Gew.-% beträgt und
die Konzentration der organischen Schwefelverbindung(en) von 0,01 bis 10 Gew.-% beträgt.

13. Ätzverfahren nach Anspruch 10 oder Anspruch 11, wobei die Konzentration der α-Hydroxycarboxylsäure und/oder des Salzes davon von 0,2 bis 5 Gew.-% beträgt.

## Revendications

1. Liquide de gravure destiné à l'attaque du titane sélectivement en présence de cuivre, comprenant :
au moins un acide choisi dans le groupe constitué de l'acide sulfurique, de l'acide chlorhydrique et de l'acide trichloroacétique ; et
au moins un composé organique sulfuré choisi parmi un composé thioéther, dans lequel le composé thioéther est choisi dans le groupe constitué de la méthionine, d'un chlorhydrate d'un ester d'alkyle de la méthionine, de l'éthionine, des acides 2-hydroxy-4-(alkylthio) butyrique et des acides 3-(alkylthio) propioniques.

2. Liquide de gravure selon la revendication 1, dans lequel le composé thioéther est au moins l'un choisi dans le groupe constitué de la méthionine, de l'éthionine et de l'acide 3-(méthylthio)propionique.

3. Liquide de gravure selon la revendication 1, dans lequel le liquide comprend en outre un acide α-hydroxycarboxylique et/ou un sel de celui-ci.

4. Liquide de gravure selon l'une quelconque des revendications 1 et 3, dans lequel l'acide α-hydroxycarboxylique est au moins un acide choisi dans le groupe constitué de l'acide tartarique, de l'acide malique, de l'acide citrique, de l'acide lactique et de l'acide glycérique.

5. Liquide de gravure selon l'une quelconque des revendications 1 à 4, dans lequel la concentration du ou des acides est comprise entre 20 et 70 % en poids, et la concentration du ou des composés organiques sulfurés est comprise entre 0,01 et 10 % en poids.

6. Liquide de gravure selon la revendication 4 ou la revendication 5, dans lequel la concentration de l'acide α-hydroxycarboxylique et/ou du sel de celui-ci est comprise entre 0,2 et 5 % en poids.

7. Procédé de gravure, comprenant l'attaque du titane sélectivement en présence de cuivre en utilisant un liquide de gravure destiné à l'attaque du titane sélectivement en présence de cuivre, comprenant :
au moins un acide choisi dans le groupe constitué de l'acide sulfurique, de l'acide chlorhydrique et de l'acide trichloroacétique ; et
au moins un composé organique sulfuré choisi dans le groupe constitué d'un composé thiocétone et d'un composé thioéther.

8. Procédé de gravure selon la revendication 7, dans lequel le composé thiocétone est au moins l'une choisie dans le groupe constitué de la thiourée, de la diéthylthiourée et de la triméthylthiourée.

9. Procédé de gravure selon la revendication 7 ou la revendication 8, dans lequel le composé thioéther est au moins l'un choisi dans le groupe constitué de la méthionine, de l'éthionine et de l'acide 3-(méthylthio)propionique.

10. Procédé de gravure selon l'une quelconque des revendications 7 à 9, dans lequel le liquide de gravure comprend en outre un acide α-hydroxycarboxylique, et/ou un sel de celui-ci.

11. Procédé de gravure selon la revendication 10, dans lequel l'acide α-hydroxycarboxylique est au moins un acide choisi dans le groupe constitué de l'acide tartarique, de l'acide malique, de l'acide citrique, de l'acide lactique et de l'acide glycérique.

12. Procédé de gravure selon l'une quelconque des revendications 7 à 11, dans lequel la concentration du ou des acides est comprise entre 20 et 70 % en poids, et la concentration du ou des composés organiques sulfurés est comprise entre 0,01 et 10 % en poids.

13. Procédé de gravure selon la revendication 10 ou la revendication 11, dans lequel la concentration de l'acide α-hydroxycarboxylique et/ou du sel de celui-ci est comprise entre 0,2 et 5 % en poids.
